# FASCICULE DE BREVET EUROPEEN

(11) **EP 2 472 624 B1**
(45) Date de publication et mention de la délivrance du brevet: **29.07.2015**
(21) Numéro de dépôt: 11193987.2
(22) Date de dépôt: 16.12.2011
(51) Int. Cl.: H01L 45/00

(54) **Procédé de gravure d'un dispositif microélectronique à mémoire programmable**
Ätzverfahren für eine mikroelektronische programmierbare Speichervorrichtung
Method for etching a microelectronic programmable memory device

(30) Priorité: 29.12.2010 FR 1061337
(43) Date de publication de la demande: 04.07.2012
(73) Titulaire: Altis Semiconductor, 91105 Corbeil Essonnes Cedex (FR)
(72) Inventeur: Cholet, Stéphane, 92260 Fontenay aux Roses (FR)
(74) Mandataire: Peguet, Wilfried

(56) Documents cités:
- US-A1- 2003 194 865
- US-A1- 2005 274 942
- US-B1- 6 831 019

## Description

La présente invention se rapporte à un procédé de gravure d'un dispositif microélectronique à mémoire programmable, ainsi qu'à un dispositif électronique à mémoire programmable obtenu par ledit procédé.

Les dispositifs microélectroniques à mémoire programmable sont typiquement, mais non exclusivement, des cellules programmables à conduction ionique (métallisation), qui sont des mémoires d'ordinateurs dites « non-volatiles». Ces cellules programmables à conduction ionique sont connues sous la dénomination CBRAM, pour l'anglicisme « *Conductive-Bridging Random Access Memory* », ou PMC, pour l'anglicisme « *Programmable Metallization Cell* ».

Ce type de structure microélectronique (CBRAM ou PMC) est par exemple décrit dans le document US 6 084 796.

Une CBRAM (ou PMC) comporte typiquement un empilement vertical de couches formé d'un substrat à base d'un semi-conducteur du type silicium, sur lequel sont déposées les couches successives suivantes : une électrode dite inférieure (« bottom electrode »), une couche d'un verre de chalcogénure dopé avec de l'argent (i.e. électrolyte solide), et une électrode dite supérieure (« top electrode ») en argent. La couche d'un verre de chalcogénure est intercalée entre l'électrode inférieure et l'électrode supérieure.

Ces électrodes sont configurées pour faire croître une dendrite métallique (i.e. formation d'un pont de conduction électrique) du négatif des deux électrodes vers le positif des deux électrodes à travers la couche de verre de chalcogénure dopé lorsqu'une tension est appliquée entre lesdites électrodes. En appliquant une tension opposée entre ces deux électrodes, on obtient le phénomène inverse, à savoir la disparition de la dendrite métallique (i.e. disparition du pont de conduction électrique) au sein de la couche de verre de chalcogénure dopé.

Ainsi, lorsque le pont de conduction électrique est créé (étape dite « d'écriture »), l'état logique du dispositif peut être représenté par « 1 », ou peut correspondre à l'état « ON », tandis que lorsque le pont de conduction électrique disparaît, l'état logique de la cellule peut être représenté par « 0 », ou peut correspondre à l'état « OFF ».

Pour réaliser les motifs de la structure microélectronique CBRAM, il est courant de réaliser une gravure de l'électrode supérieure et du verre de chalcogénure dopé à l'aide d'un masque dur ou « hard mask ». Cette gravure est classiquement réalisée à haute température dans une chambre de gravure métallique en utilisant un plasma.

Toutefois, après cette étape de gravure, de nombreux défauts apparaissent non seulement à la surface des couches non couvertes par le masque dur, dites « surfaces ouvertes », mais aussi aux extrémités des couches gravées.

Ces défauts sont liés aux différents éléments métalliques contenus dans les couches de la structure microélectroniques CBRAM, tels que par exemple l'argent contenu dans la couche de verre de chalcogénure et dans l'électrode supérieure. Ces éléments métalliques sont des éléments non volatils, mais chimiquement très réactifs et très mobiles.

Plus particulièrement, les défauts métalliques à la surface des couches ouvertes proviennent de la migration verticale de ces éléments métalliques dans l'empilement CBRAM. Et les défauts métalliques aux extrémités des couches gravées ont pour origine la migration horizontale des éléments métalliques dans l'empilement CBRAM.

Ces défauts métalliques dégradent de façon significative la qualité des structures microélectronique CBRAM et limitent ainsi leurs performances électriques, voire même les rendent non fonctionnelles.

Le but de la présente invention est de pallier les inconvénients des techniques de l'art antérieur en proposant notamment un procédé de gravure plasma d'un dispositif électronique à mémoire programmable permettant de limiter de façon significative, voire d'éviter, l'apparition de défauts métalliques au sein dudit dispositif tout en garantissant une vitesse de gravure très satisfaisante (i.e. un très bonne productivité industrielle).

La présente invention a pour objet un procédé de gravure d'un dispositif microélectronique à mémoire programmable comportant un substrat recouvert par au moins les couches successives suivantes:
- une première électrode (i.e. électrode inférieure ou « *bottom electrode* ») à base d'un premier élément métallique,
- une couche de chalcogénure dopé avec un deuxième élément métallique,
- une deuxième électrode (i.e. électrode supérieure ou « *top electrode* ») à base d'un troisième élément métallique,
- une couche électriquement conductrice du type barrière de diffusion, et
- un masque dur,
le procédé comprenant une étape consistant à graver à l'aide d'un plasma de gaz inerte au moins le masque dur, la couche électriquement conductrice, la deuxième électrode, et la couche de chalcogénure,
l'étape de gravure étant caractérisée en ce qu'elle s'effectue par pulvérisation cathodique, à une température strictement inférieure à 150°C, de préférence à une température d'au plus 120°C, et de façon particulièrement préférée à une température d'au plus 100°C.

Les premier, deuxième et troisième éléments métalliques peuvent être identiques ou différents.

La demanderesse a découvert de façon surprenante qu'en limitant la température lors du procédé de gravure plasma selon l'invention, les défauts métalliques disparaissaient significativement.

Par conséquent, l'activation de la mobilité des éléments métalliques, notamment de l'argent, dans le dispositif microélectronique de l'invention, est fortement limitée durant l'étape de gravure selon l'invention, et ainsi la densité de défauts métalliques après la gravure en est significativement diminuée.

### L'étape de gravure plasma

Selon la présente invention, la gravure d'attaque du masque dur est notamment moins rapide que la gravure d'attaque de la deuxième électrode, de sorte à ce que, à la fin de l'étape de gravure, le masque dur ne soit pas gravé (i.e. éliminé) en totalité.

Plus particulièrement, l'étape de gravure dépend de deux paramètres tels que la vitesse de gravure et l'épaisseur des couches à graver.

Ainsi, l'homme du métier peut faire varier au moins un de ces deux paramètres, tel que par exemple, il peut :
i. jouer sur la différence de vitesse de gravure entre le masque dur et la deuxième électrode,
ii. jouer sur la différence d'épaisseur entre le masque dur et la deuxième électrode,
iii. jouer sur les paramètres i et ii.

L'étape de gravure selon l'invention s'effectue classiquement à l'intérieur d'une chambre de gravure comportant un porte-échantillon. La température à laquelle s'effectue la gravure par pulvérisation cathodique est plus particulièrement la température dudit porte-échantillon sur lequel est positionné le dispositif électronique à mémoire programmable, la partie en contact physique avec le porte-échantillon étant le substrat.

La pulvérisation cathodique à l'aide d'un plasma de gaz inerte est un procédé bien connu de l'homme du métier sous l'anglicisme « *sputtering* » notamment pour déposer des couches minces d'un matériau à partir de la condensation d'une vapeur métallique issue d'une source solide (i.e. cible) sur un substrat positionné sur un porte-échantillon.

Dans le cadre de la présente invention, la cible correspond à l'empilement vertical des couches selon l'invention. De ce fait, une cible indépendante dudit empilement n'est pas nécessaire. L'objet de la pulvérisation cathodique est d'enlever au moins une partie, et de préférence la totalité, de la deuxième électrode et de la couche de chalcogénure, non protégées par le masque dur.

Ainsi, la gravure par pulvérisation cathodique selon l'invention est plus particulièrement une gravure dite mécanique, ou en d'autres termes une gravure qui n'est pas chimique, à savoir elle ne concerne pas la combinaison de deux matériaux pour en former un troisième, par exemple par condensation chimique.

La chambre de gravure utilisée pour réaliser le procédé selon l'invention peut être une chambre de gravure, qui est une chambre de gravure diélectrique pour masque souple (« *soft mask* ») ou masque de résine.

De préférence, le plasma de gaz inerte utilisé dans le procédé de l'invention est un plasma de gaz chimiquement inactif.

Plus particulièrement, ledit plasma de gaz chimiquement inactif peut comprendre uniquement un ou plusieurs gaz chimiquement inactifs.

Le ou les gaz chimiquement inactifs peuvent être choisis parmi les éléments de la colonne 18 (VIIIA) du tableau périodique des éléments, tel que par exemple l'argon (Ar), l'hélium (He), le Néon (Ne).

### Le dispositif microélectronique à mémoire programmable

Le dispositif microélectronique à mémoire programmable de l'invention comprend typiquement un empilement vertical de couches formé du substrat sur lequel sont déposées les couches successives suivantes : la première électrode à base du premier élément métallique, la couche de chalcogénure dopé avec le deuxième élément métallique, la deuxième électrode à base du troisième élément métallique, la couche électriquement conductrice, et le masque dur.

D'autres couches bien connues de l'homme du métier peuvent être intercalées entre celles mentionnées ci-avant.

### - Le substrat

Dans la présente invention, le terme « substrat » peut comprendre tout type de structures.

On peut citer notamment les substrats semi-conducteurs, pouvant être classiquement à base de silicium et/ou de quartz. A titre d'exemple, le substrat semi-conducteur peut être choisi parmi les substrats de silicium, d'oxyde de silicium, et de quartz.

Le substrat semi-conducteur peut comprendre par exemple des semi-conducteurs de type silicium sur isolant (*"silicon on insulator",* SOI), silicium sur saphir (*"silicon on sapphire",* SOS), des semi-conducteurs dopés ou non dopés, des couches de silicium épitaxiées sur une base semi-conductrice. Des étapes de procédé pourront avoir été utilisées pour former des régions ou des jonctions dans ou au-dessus de la base semi-conductrice.

Le substrat n'est pas nécessairement semi-conducteur, mais peut être n'importe quel type de structure support adapté pour supporter un circuit intégré. Par exemple, le substrat peut être en céramique ou à base de polymère.

A titre d'exemple, le substrat peut avoir une épaisseur allant de 150 µm à 400 µm, voire allant jusqu'à 800 µm.

### - La première et la deuxième électrodes

Les première et deuxième électrodes sont notamment des électrodes métalliques, respectivement à base d'un premier et d'un troisième éléments métalliques, réalisées et déposées par des techniques bien connues de l'homme du métier. Elles correspondent respectivement à une anode et à une cathode, ou inversement.

Le premier élément métallique peut être typiquement choisi parmi du nickel, du tungstène, un alliage de nickel, et un alliage de tungstène.

Le troisième élément métallique peut être typiquement choisi parmi de l'argent, et un alliage d'argent tel que par exemple du tantalate d'argent.

Dans un mode de réalisation particulier, le dispositif microélectronique à mémoire programmable selon l'invention peut comporter en outre une couche électriquement isolante (i.e. ou couche diélectrique), intercalée entre le substrat et la couche de chalcogénure.

Cette couche électriquement isolante peut être positionnée au même niveau (horizontal) que la première électrode, et plus particulièrement elle peut s'étendre de part et d'autre de la première électrode. La couche de chalcogénure reste ainsi en contact électrique avec la première électrode.

Lorsque le dispositif microélectronique à mémoire programmable comprend au moins deux empilements, ladite couche électriquement isolante permet d'isoler électriquement un premier empilement par rapport à un deuxième empilement, les deux empilements étant positionnés l'un à côté de l'autre en configuration opérationnelle.

De préférence, cette couche électriquement isolante a une épaisseur identique à celle de la première électrode.

A titre d'exemple, cette couche électriquement isolante peut être une couche de nitrure de silicium (Si₃N₄).

### - La couche de chalcogénure

La couche de chalcogénure dopée est classiquement intercalée entre la première et la deuxième électrode afin de pouvoir former des ponts conducteurs électriques lorsqu'une tension est appliquée entre ces deux électrodes. Par conséquent, la couche de chalcogénure doit être en contact physique avec les deux électrodes.

Plus particulièrement, pour les CBRAM (ou PMC), les deux électrodes sont configurées pour faire croître une dendrite métallique (i.e. formation d'un pont de conduction électrique) du négatif des deux électrodes vers le positif des deux électrodes à travers la couche de chalcogénure dopée lorsqu'une tension est appliquée entre lesdites électrodes. En appliquant une tension opposée entre ces deux électrodes, on obtient le phénomène inverse, à savoir la disparition de la dendrite métallique (i.e. disparition du pont de conduction électrique) au sein de la couche intermédiaire dopée.

Ainsi, si une couche intermédiaire est positionnée entre une électrode et la couche de chalcogénure, il est essentiel que la couche de chalcogénure soit en contact électrique avec ladite électrode, par exemple par l'intermédiaire de matériaux conducteurs permettant de relier électriquement la couche de chalcogénure à ladite électrode.

Selon l'invention, le matériau constitutif de la couche de chalcogénure comprend un chalcogénure composé d'au moins un ion chalcogène et d'au moins un élément électropositif. Plus particulièrement, ce matériau peut être un verre de chalcogénure.

Un chalcogénure peut être représenté par la formule suivante : AₓB₁₀₀₋ₓ, dans laquelle A est un élément électropositif, B un ion chalcogène, et x un nombre entier compris entre 1 et 99.

Les chalcogènes, constitutifs des ions chalcogènes, sont rassemblés classiquement dans le groupe 16 du tableau périodique des éléments, et ceux utilisés de préférence dans l'invention sont le soufre (S), le sélénium (Se) et le tellure (Te).

L'élément électropositif constitutif du chalcogénure peut être plus particulièrement :
- un élément du groupe 14 (i.e. groupe IVA) du tableau périodique des éléments, tel que notamment le silicium (Si) ou le germanium (Ge), ou
- un élément du groupe 15 (i.e. groupe VA) du tableau périodique des éléments, tel que notamment le phosphore (P), l'arsenic (As), l'antimoine (Sb) ou le bismuth (Bi).

De préférence, ledit élément électropositif est le germanium (Ge) ou l'arsenic (As).

On parle typiquement de verre de chalcogénure lorsque l'élément électropositif du chalcogénure appartient au groupe 14 ou au groupe 15 du tableau périodique des éléments.

On peut citer à titre d'exemple de chalcogénure, le séléniure de germanium GeₓSe₁₀₀₋ₓ, le sulfure de germanium GeₓS₁₀₀₋ₓ, ou le sulfure d'arsenic AsₓS₁₀₀₋ₓ, x étant un nombre entier compris entre 1 et 99.

Le chalcogénure préféré est le sulfure de germanium GeₓS₁₀₀₋ₓ, notamment avec x = 33 (i.e. GeS₂).

Le deuxième élément métallique qui est l'élément dopant du chalcogénure peut être préférentiellement de l'argent.

Dans un mode de réalisation préféré, le deuxième élément métallique est identique au troisième élément métallique.

Dans un autre mode de réalisation préférée, le deuxième élément métallique et/ou le troisième élément métallique est de l'argent.

### - La couche électriquement conductrice

La couche électriquement conductrice selon l'invention, du type couche intermédiaire, permet de faire un écran de diffusion aux éléments métalliques mobiles compris notamment dans les couches sous-jacentes ou couches inférieures du dispositif microélectronique.

Notamment, la couche conductrice est destinée à faire une barrière de diffusion à au moins un des trois éléments métalliques, de préférence au deuxième et au troisième éléments métalliques.

A titre d'exemple, cette couche conductrice du type barrière de diffusion est une couche de titane (Ti), d'un alliage de titane tel que par exemple du nitrure de titane (TiN), de tantale (Ta), ou d'un alliage de tantale tel que par exemple du nitrure de tantale (TaN).

### - Le masque dur

Le masque dur selon l'invention peut comprendre une couche électriquement conductrice et/ou une couche électriquement isolante (i.e. ou couche diélectrique).

Selon un premier mode de réalisation, le masque dur peut comprendre uniquement une ou plusieurs couches électriquement conductrices.

Selon un deuxième mode de réalisation, le masque dur peut comprendre la couche électriquement isolante déposée sur la couche électriquement conductrice.

Par ailleurs, la couche électriquement conductrice du type couche intermédiaire et la couche électriquement conductrice du masque dur peuvent être une seule et même couche.

Plus particulièrement, la couche électriquement isolante du masque dur est une couche d'un matériau électriquement isolant, telle que par exemple une couche diélectrique d'un oxyde (e.g. oxyde de silicium). La couche électriquement conductrice est une couche d'un matériau électriquement conducteur, telle que par exemple une couche métallique de nitrure de titane.

Un autre objet selon l'invention concerne un dispositif microélectronique à mémoire programmable obtenu à partir du procédé tel que défini dans la présente invention.

Ledit dispositif microélectronique ainsi obtenu présente une densité de défauts métalliques (i.e. comptage visuel du nombre de défauts métalliques par unité de surface) trois fois moins importantes, de préférence dix fois moins importantes, et de façon particulièrement préférée cent fois moins importante, que la densité de défauts d'un dispositif identique ayant subi une étape de gravure dans les même conditions que celles spécifiées dans l'invention, mais à une température d'au moins 150°C.

D'autres caractéristiques et avantages de la présente invention apparaîtront à la lumière des exemples qui vont suivre en référence aux figures annotées, lesdits exemples et figures étant donnés à titre illustratif et nullement limitatif.

La figure 1 représente une vue partielle en coupe transversale d'un empilement de couches d'un dispositif microélectronique avant gravure, selon l'invention.

La figure 2 représente une vue partielle en coupe transversale de l'empilement de couches de la figure 1, après gravure selon l'invention.

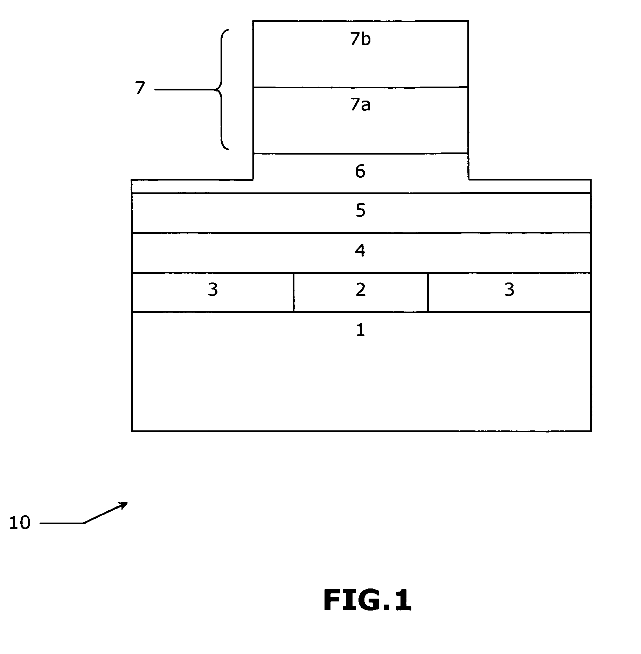

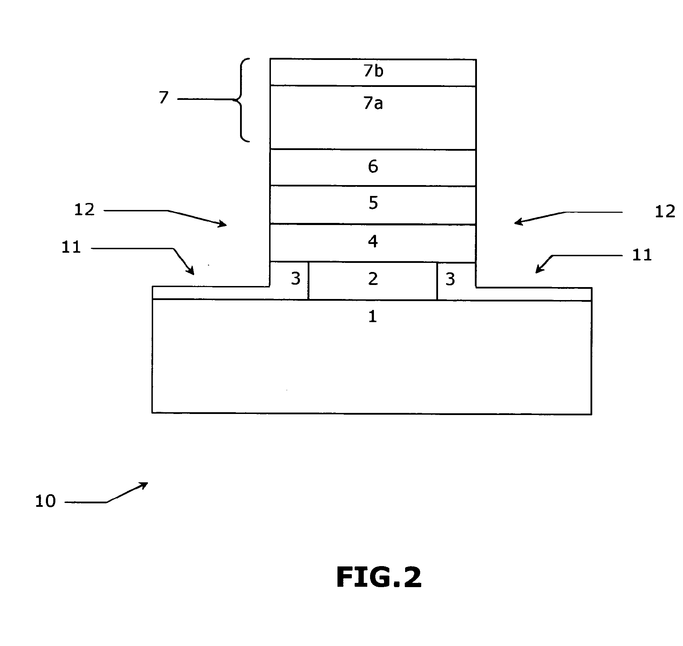

Les qualificatifs « supérieur », « inférieur », « vertical » et « horizontal » sont définis dans la présente invention par rapport au positionnement d'un dispositif microélectronique tel que représenté sur les figures 1 à 2.

La figure 1 représente un empilement (10) particulier formant un dispositif microélectronique avant l'application du procédé de gravure selon la présente invention.

Ledit empilement (10) comprend les couches successives suivantes :
- un substrat (1) comprenant au moins une couche à base de silicium, et optionnellement une succession d'éléments bien connus de l'homme du métier, l'épaisseur du substrat étant de 300 µm,
- une couche (2) de tungstène formant la première électrode (ou électrode inférieure), l'épaisseur cette couche étant de 100 nm,
- de part et d'autre de la couche de tungstène s'étend horizontalement une couche (3) de nitrure de silicium (Si₃N₄) formant la couche électriquement isolante, l'épaisseur de cette couche étant identique à celle de la couche de tungstène,
- une couche (4) d'un verre de chalcogénure de type GeS₂, dopé à l'argent, l'épaisseur de cette couche étant de l'ordre de 50 nm,
- une couche (5) d'argent formant la deuxième électrode (ou électrode supérieure), l'épaisseur cette couche étant de l'ordre de 30 nm,
- une couche (6) de nitrure de tantale (TaN) formant la couche électriquement conductrice, l'épaisseur de cette couche étant de l'ordre de 10 nm,
- une couche (7a) de nitrure de titane (TiN) formant la couche électriquement conductrice du masque dur (7), l'épaisseur de cette couche étant de l'ordre de 50 nm, et
- une couche (7b) d'oxyde formant la couche électriquement isolante du masque dur (7), l'épaisseur de cette couche étant de l'ordre de 80 nm.

Cet empilement (10) (empilement A) est placé dans une chambre de gravure métallique, ladite chambre étant commercialisée par la société Applied Materials sous la référence *Hot DPS2.*

En parallèle, on a placé le même empilement (empilement B) dans une chambre de gravure diélectrique, ladite chambre étant commercialisée par la société Applied Materials sous la référence *Cold DPS2.*

A l'intérieur de ces deux chambres, ledit empilement est posé sur la surface d'un porte-échantillon au sein de ladite chambre.

L'étape de gravure dudit empilement s'effectue par pulvérisation cathodique à l'aide d'un plasma d'argon pendant une durée d'environ 150 secondes.

Les températures mises en oeuvre lors de la gravure sont les suivantes :
- dans la chambre « Hot DPS2 », la température est de 150°C (essai comparatif), et
- dans la chambre « Cold DPS2 », la température est de 60°C (essai selon l'invention).

Plus particulièrement, la température mentionnée ici est la température du porte-échantillon sur lequel est positionné l'empilement (10), la partie en contact physique avec le porte-échantillon étant le substrat (1).

A la fin de la gravure, on observe à l'aide d'un microscope optique de la société LEICA, les surfaces des empilements A et B avec un grossissement de 150.

L'empilement A présente une densité de défauts d'argent (i.e. comptage visuel du nombre de défauts d'argent par unité de surface) importante. En effet, on observe des défauts d'argent :
- au niveau des surfaces ouvertes (11), liés à la migration ou à la diffusion verticale de l'argent contenu dans la couche d'argent (5) utilisée en tant qu'électrode supérieure, et dans la couche de chalcogénure (4) dopé à l'argent : on parle alors de résidus d'argent dans les surfaces ouvertes, et
- au niveau des extrémités (12) de l'empilement A, liés à la migration ou à la diffusion horizontale de l'argent contenu dans la couche d'argent (5) utilisée en tant qu'électrode supérieure, et dans la couche de chalcogénure (4) dopé à l'argent : on parle alors de défauts d'extrusion d'argent.

En effet, à une température supérieure ou égale à 150°C, le mécanisme d'apparition des défauts d'argent après gravure est directement lié à la mobilité de l'argent dans l'empilement. L'argent a la capacité de se déplacer à l'intérieur de l'empilement et de générer des non-homogénéités locales avec des zones très concentrées en argent.

L'empilement B présente, quant à lui, une densité de défauts d'argent beaucoup plus faible (e.g cent fois plus faible) que celle observé sur l'empilement A. Ainsi, l'activation de la mobilité de l'argent contenu dans l'empilement B a été limitée fortement, ce qui permet de garantir un meilleur contrôle de la diffusion de l'argent au sein de la couche de chalcogénure. De ce fait, cette limitation de défauts d'argent dans l'empilement B se traduit par une amélioration significative des performances électriques lors de l'utilisation de l'empilement B en tant que CBRAM.

En outre, la vitesse de gravure de l'empilement B est sensiblement la même que la vitesse de gravure de l'empilement A. Il n'y a donc pas de perte de productivité.

La demanderesse a ainsi découvert un procédé de gravure à basse température, utilisant notamment une chambre de gravure diélectrique, ayant une vitesse de gravure très satisfaisante tout en réduisant de façon significative la quantité des défauts métalliques après gravure.

## Revendications

1. Procédé de gravure d'un dispositif microélectronique à mémoire programmable (10) comportant un substrat (1) recouvert par au moins les couches successives suivantes:
- une première électrode (2) à base d'un premier élément métallique,
- une couche (4) de chalcogénure dopé avec un deuxième élément métallique,
- une deuxième électrode (5) à base d'un troisième élément métallique,
- une couche électriquement conductrice (6) du type barrière de diffusion, et
- un masque dur (7),
le procédé comprenant une étape consistant à graver à l'aide d'un plasma de gaz inerte au moins le masque dur (7), la couche électriquement conductrice (6), la deuxième électrode (5), et la couche de chalcogénure (4),
l'étape de gravure étant **caractérisée en ce qu'**elle s'effectue par pulvérisation cathodique, à une température strictement inférieure à 150°C, de préférence à une température d'au plus 120°C, et de façon particulièrement préférée à une température d'au plus 100°C.

2. Procédé de gravure selon la revendication 1, **caractérisé en ce que** la gravure est une gravure dite mécanique.

3. Procédé de gravure selon la revendication 1 ou 2, **caractérisé en ce que** le plasma de gaz inerte est un plasma d'argon.

4. Procédé de gravure selon l'une quelconque des revendications précédentes, **caractérisé en ce que** le masque dur (7) comprend une couche électriquement conductrice (7a) et/ou une couche électriquement isolante (7b).

5. Procédé de gravure selon la revendication 4, **caractérisé en ce que** la couche électriquement conductrice (7a) est une couche de nitrure de titane (TiN).

6. Procédé de gravure selon la revendication 4 ou 5, **caractérisé en ce que** la couche électriquement isolante (7b) est déposée sur la couche électriquement conductrice (7a).

7. Procédé de gravure selon l'une quelconque des revendications précédentes, **caractérisé en ce que** la couche électriquement conductrice (6) du type barrière de diffusion est une couche de nitrure de tantale (TaN).

8. Procédé de gravure selon l'une quelconque des revendications précédentes, **caractérisé en ce que** la couche de chalcogénure (4) comprend du GeS₂.

9. Procédé de gravure selon l'une quelconque des revendications précédentes, **caractérisé en ce que** le deuxième élément métallique est identique au troisième élément métallique.

10. Procédé de gravure selon l'une quelconque des revendications précédentes, **caractérisé en ce que** le deuxième élément métallique et/ou le troisième élément métallique est de l'argent.

11. Procédé de gravure selon l'une quelconque des revendications précédentes, **caractérisé en ce que** le dispositif microélectronique à mémoire programmable (10) comporte en outre une couche électriquement isolante (3) intercalée entre le substrat (1) et la couche (4) de chalcogénure.

12. Procédé de gravure selon la revendication 11, **caractérisé en ce que** la couche électriquement isolante (3) est une couche de nitrure de silicium (Si₃N₄).

13. dispositif microélectronique à mémoire programmable obtenu à partir du procédé selon l'une quelconque des revendications 1 à 12.

## Patentansprüche

1. Ätzverfahren für eine mikroelektronische programmierbare Speichervorrichtung (10), die ein Substrat (1) aufweist, das durch mindestens die folgenden aufeinanderfolgenden Schichten bedeckt ist:
- eine erste Elektrode (2) auf der Basis eines ersten metallischen Elements,
- eine mit einem zweiten metallischen Element dotierte Chalkogenidschicht (4),
- eine zweite Elektrode (5) auf der Basis eines dritten metallischen Elements,
- eine elektrisch leitende Schicht (6) vom Typ Diffusionsbarriere und
- eine harte Maske (7),
wobei das Verfahren einen Schritt umfasst, der darin besteht, mindestens die harte Maske (7), die elektrisch leitende Schicht (6), die zweite Elektrode (5) und die Chalkogenidschicht (4) mit Hilfe eines Inertgasplasmas zu ätzen,
wobei der Ätzschritt **dadurch gekennzeichnet ist, dass** er durch Kathodenzerstäubung bei einer Temperatur strikt unter 150 °C, vorzugsweise bei einer Temperatur von höchstens 120 °C, und in besonders bevorzugter Weise bei einer Temperatur von höchstens 100 °C erfolgt.

2. Ätzverfahren nach Anspruch 1, **dadurch gekennzeichnet, dass** das Ätzen ein mechanisches Ätzen ist.

3. Ätzverfahren nach Anspruch 1 oder 2, **dadurch gekennzeichnet, dass** das Inertgasplasma ein Argonplasma ist.

4. Ätzverfahren nach einem der vorangehenden Ansprüche, **dadurch gekennzeichnet, dass** die harte Maske (7) eine elektrisch leitende Schicht (7a) und/oder eine elektrisch isolierende Schicht (7b) umfasst.

5. Ätzverfahren nach Anspruch 4, **dadurch gekennzeichnet, dass** die elektrisch leitende Schicht (7a) eine Titannitridschicht (TiN) ist.

6. Ätzverfahren nach Anspruch 4 oder 5, **dadurch gekennzeichnet, dass** die elektrisch isolierende Schicht (7b) auf die elektrisch leitende Schicht (7a) aufgebracht ist.

7. Ätzverfahren nach einem der vorangehenden Ansprüche, **dadurch gekennzeichnet, dass** die elektrisch leitende Schicht (6) vom Typ Diffusionsbarriere eine Tantalnitridschicht (TaN) ist.

8. Ätzverfahren nach einem der vorangehenden Ansprüche, **dadurch gekennzeichnet, dass** die Chalkogenidschicht (4) GeS₂ umfasst.

9. Ätzverfahren nach einem der vorangehenden Ansprüche, **dadurch gekennzeichnet, dass** das zweite metallische Element mit den dritten metallischen Element identisch ist.

10. Ätzverfahren nach einem der vorangehenden Ansprüche, **dadurch gekennzeichnet, dass** das zweite metallische Element und/oder das dritte metallische Element Silber ist.

11. Ätzverfahren nach einem der vorangehenden Ansprüche, **dadurch gekennzeichnet, dass** die mikroelektronische programmierbare Speichervorrichtung (10) ferner eine elektrisch isolierende Schicht (3) zwischen dem Substrat (1) und der Chalkogenidschicht (4) aufweist.

12. Ätzverfahren nach Anspruch 11, **dadurch gekennzeichnet, dass** die elektrisch isolierende Schicht (3) eine Siliziumnitridschicht (Si₃N₄) ist.

13. Mikroelektronische programmierbare Speichervorrichtung, hergestellt nach dem Verfahren nach einem der Ansprüche 1 bis 12.

## Claims

1. A method for etching a microelectronic device with a programmable memory (10) including a substrate (1) covered with at least the following successive layers:
- a first electrode (2) based on a first metal element,
- a layer (4) of chalcogenide doped with a second metal element,
- a second electrode (5) based on a third metal element,
- an electrically conducting layer (6) of the diffusion barrier type , and
- a hard mask (7),
the method comprising a step consisting of etching by means of an inert gas plasma at least the hard mask (7), the electrically conducting layer (6), the second electrode (5), and the chalcogenide layer (4),
the etching step being **characterized in that** it is carried out by cathode sputtering, at a temperature strictly less than 150°C, preferably at a temperature of at most 120°C, and more preferably at a temperature of at most 100°C.

2. The etching method according to claim 1, **characterized in that** the etching is so-called mechanical etching.

3. The etching method according to claim 1 or 2, **characterized in that** the inert gas plasma is argon plasma.

4. The etching method according to any of the preceding claims, **characterized in that** the hard mask (7) comprises an electrically conducting layer (7a) and/or an electrically insulating layer (7b).

5. The etching method according to claim 4, **characterized in that** the electrically conducting layer (7a) is a titanium nitride (TiN) layer.

6. The etching method according to claim 4 or 5, **characterized in that** the electrically insulating layer (7b) is deposited on the electrically conducting layer (7a).

7. The etching method according to any of the preceding claims, **characterized in that** the electrically conducting layer (6) of the diffusion barrier type is a tantalum nitride (TaN) layer.

8. The etching method according to any of the preceding claims, **characterized in that** the chalcogenide layer (4) comprises GeS₂.

9. The etching method according to any of the preceding claims, **characterized in that** the second metal element is identical with the third metal element.

10. The etching method according to any of the preceding claims, **characterized in that** the second metal element and/or the third metal element is silver.

11. The etching method according to any of the preceding claims, **characterized in that** the microelectronic device with a programmable memory (10) further includes an electrically insulating layer (3) inserted between the substrate (1) and the chalcogenide layer (4).

12. The etching method according to claim 11, **characterized in that** the electrically insulating layer (3) is a silicon nitride (Si₃N₄) layer.

13. An electronic device with a programmable memory obtained from the method according to any of claims 1 to 12.
